(19) Europäisches Patentamt
European Patent Office
Office européen des brevets

(11) EP 3 407 077 A1

(12) EUROPEAN PATENT APPLICATION
published in accordance with Art. 153(4) EPC

(43) Date of publication:
28.11.2018 Bulletin 2018/48

(51) Int Cl.:
G01R 33/02 (2006.01)  G01R 33/07 (2006.01)
G01B 7/00 (2006.01)  G01D 5/14 (2006.01)

(21) Application number: 17773720.2

(22) Date of filing: 10.02.2017

(86) International application number:
PCT/JP2017/004929

(87) International publication number:
WO 2017/169172 (05.10.2017 Gazette 2017/40)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 30.03.2016 JP 2016068269

(71) Applicant: KYB Corporation
Tokyo 105-6111 (JP)

(72) Inventor: HEISHI, Tsukasa
Tokyo 105-6111 (JP)

(74) Representative: Grünecker Patent- und
Rechtsanwälte
PartG mbB
Leopoldstraße 4
80802 München (DE)

(54) MAGNETIC DETECTING UNIT AND STROKE DETECTING DEVICE PROVIDED WITH SAME

(57) A magnetic detection unit (51 and 52) includes: a first magnet (53) configured to generate a first magnetic field; a second magnet (54) arranged in parallel with the first magnet (53), the second magnet (54) being configured to generate a second magnetic field in a direction opposite to a direction of the first magnetic field; and a hall element (56) having a magnetic-flux detection surface (56a), the hall element (56) being configured to output a signal corresponding to a magnetic flux density passing through the magnetic-flux detection surface (56a). The hall element (56) is arranged at a position where a direction of a magnetic flux in a synthetic magnetic field of the first magnetic field and the second magnetic field is parallel to the magnetic-flux detection surface (56a).

## Description

### TECHNICAL FIELD

The present invention relates to a magnetic detection unit and a stroke detector including the same.

### BACKGROUND ART

Conventionally, stroke detectors are used for detecting the stroke of a linear motion part such as a cylinder. JP2004-286662A discloses a stroke detector in which a magnetic detection unit provided in a cylinder tube detects stroke of the cylinder by detecting scales provided on a surface of a piston rod. A magnetic detection unit of the stroke detector has a magnetic detection element that is arranged so as to oppose the scales and a magnet that is disposed on the other side of the magnetic detection element from the side opposing the scales.

### SUMMARY OF INVENTION

However, with the magnetic detection unit described in JP2004-286662A, a maximum detection range of the magnetic detection element is set in accordance with an intensity of a magnetic field passing through the magnetic detection element, in other words, the intensity of the magnetic field generated by the magnet. Because resolution is lowered with the magnetic detection element having a wide detection range, when an amount of change in the stroke is small and a change in the magnetic field is small, it is difficult to detect the change in the magnetic field. As a result, there is a posibility in that the detection precision of the stroke is deteriorated.

An object of the present invention is to improve a detection precision of a magnetic detection unit detecting a change in a magnetic field.

According to one aspect of the present invention, a magnetic detection unit includes a first magnetic-field generating part configured to generate a first magnetic field; a second magnetic-field generating part arranged in parallel with the first magnetic-field generating part, the second magnetic-field generating part being configured to generate a second magnetic field in a direction opposite to a direction of the first magnetic field; and a magnetic detection element having a magnetic-flux detection surface, the magnetic detection element being configured to output a signal corresponding to a magnetic flux density passing through the magnetic-flux detection surface. The magnetic detection element is arranged at a position where a direction of a magnetic flux in a synthetic magnetic field of the first magnetic field and the second magnetic field is parallel to the magnetic-flux detection surface.

### BRIEF DESCRIPTION OF DRAWINGS

FIG. 1 is a configuration diagram of a stroke detector including a magnetic detection unit according to an embodiment of the present invention;
FIG. 2 is a sectional view of the magnetic detection unit taken along the line II-II in FIG. 1;
FIG. 3 is a sectional view of the magnetic detection unit taken along the line III-III in FIG. 2;
FIG. 4 is a diagram for explaining a synthetic magnetic field generated by a first magnetic-field generating part and a second magnetic-field generating part of the magnetic detection unit according to the embodiment of the present invention;
FIG. 5 is a diagram for explaining detection of a magnetic flux by a magnetic detection element of the magnetic detection unit;
FIG. 6 is a diagram for explaining a change in a magnetic field in a vicinity of the magnetic detection unit caused by displacement of a cylinder;
FIG. 7 is a graph showing an output from the stroke detector including the magnetic detection unit according to the embodiment of the present invention;
FIG. 8 is a graph showing computed results by the stroke detector including the magnetic detection unit according to the embodiment of the present invention;
FIG. 9 is a sectional view of the magnetic detection unit according to a modification of the embodiment of the present invention;
FIG. 10 is a sectional view of the magnetic detection unit taken along the line X-X in FIG. 9; and
FIG. 11 is a diagram for explaining the synthetic magnetic field generated by the first magnetic-field generating part and the second magnetic-field generating part of the magnetic detection unit according to the modification of the embodiment of the present invention.

### DESCRIPTION OF EMBODIMENTS

An embodiment of the present invention will be described below with reference to the drawings.

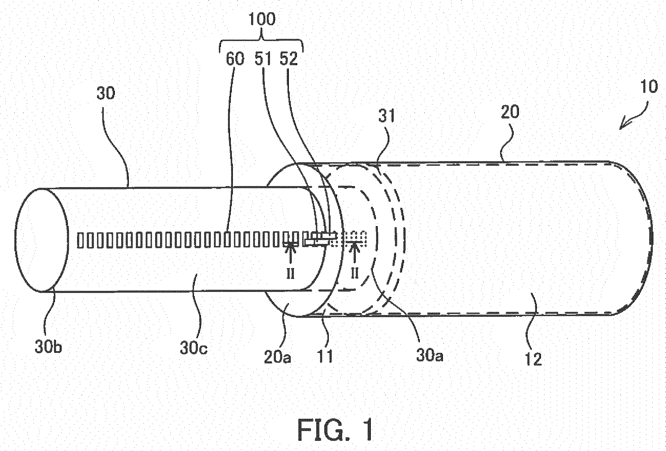

A stroke detector 100 including magnetic detection units 51 and 52 according to an embodiment of the present invention will be described with reference to FIGs. 1 to 8. A cylinder 10 shown in FIG. 1 is a hydraulic cylinder that is operated by means of working oil discharged from a hydraulic pump (not shown). The stroke detector 100 is provided in the cylinder 10.

The cylinder 10 includes a cylinder tube 20 serving as a first member that is a main body of the cylinder 10 and a piston rod 30 serving as a second member that is provided so as to be capable of advancing/retracting with respect to the cylinder tube 20. In other words, the cylinder 10 is a linear motion mechanism in which the piston rod 30 moves in an advancing/retracting manner with respect to the cylinder tube 20.

The cylinder tube 20 has a cylindrical shape, and a piston 31 is provided in the cylinder tube 20 so as to be freely slidable in the axial direction. In addition, at an end portion of the cylinder tube 20, a cylinder head 20a through which the piston rod 30 is inserted in a freely slidable manner is provided. The interior of the cylinder tube 20 is divided into two oil chambers 11 and 12 by the piston 31.

The two oil chambers 11 and 12 are connected to the hydraulic pump or a tank (not shown) via a switching valve (not shown). When one of the two oil chambers 11 and 12 is connected to the hydraulic pump, the other is connected to the tank. As the working oil is guided from the hydraulic pump to either one of the two oil chambers 11 and 12 and the piston rod 30 is moved in the axial direction, the cylinder 10 is extended/contracted. Although the cylinder 10 is a double-acting cylinder, the cylinder 10 may be a single-acting cylinder. In addition, the cylinder 10 is not limited to a hydraulic cylinder, and the cylinder 10 may also be an pneumatic cylinder, a water pressure cylinder, an electrical mechanical cylinder, or the like. In addition, the cylinder 10 is not limited to that functions as an actuator, and the cylinder 10 may function as a shock absorber, etc.

The piston rod 30 is a columnar magnetic member having a proximal end portion 30a and a distal end portion 30b, where the proximal end portion 30a is fixed to the piston 31, and the distal end portion 30b is exposed from the cylinder tube 20. The piston rod 30 is operated by hydraulic force acting on the piston 31.

Next, the stroke detector 100 provided on the cylinder 10 will be described.

The stroke detector 100 includes the first magnetic detection unit 51 and the second magnetic detection unit 52 serving as the magnetic detection units that are disposed on the cylinder head 20a through which the piston rod 30 is inserted and a plurality of scales 60 that are formed on a side surface 30c of the piston rod 30 along the advancing/retracting direction of the piston rod 30.

The first magnetic detection unit 51 and the second magnetic detection unit 52 are detection units that detect a change in an ambient magnetic field, and the first magnetic detection unit 51 and the second magnetic detection unit 52 are arranged so as to be offset in the axial direction of the piston rod 30. Because the first magnetic detection unit 51 and the second magnetic detection unit 52 have the same configuration, only the configuration of the first magnetic detection unit 51 will be described below.

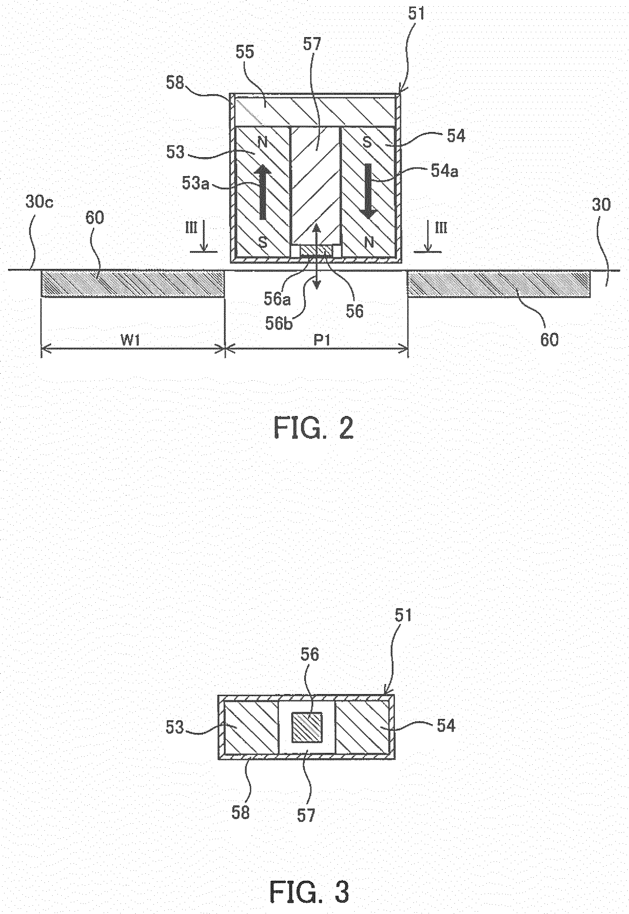

As shown in FIG. 2, the first magnetic detection unit 51 includes a first magnet 53 serving as a first magnetic-field generating part that generates a first magnetic field, a second magnet 54 arranged in parallel with the first magnet 53 and serving as a second magnetic-field generating part that generates a second magnetic field in the direction opposite to that of the first magnetic field, a yoke 55 that connects the first magnet 53 and the second magnet 54, a hall element 56 serving as a magnetic detection element that outputs signals in accordance with a magnetic flux density passing through a magnetic-flux detection surface 56a, a casing 58 that accommodates these components, and a positioning member 57 for positioning the hall element 56 in the casing 58.

The first magnet 53 and the second magnet 54 are permanent magnets, such as neodymium magnet and ferrite magnet. The first magnet 53 is arranged such that its south pole is positioned at the piston rod 30 side, and the second magnet 54 is arranged such that its north pole is positioned at the piston rod 30 side. In other words, the first magnet 53 is magnetized in the direction shown by an arrow 53a, and the second magnet 54 is magnetized in the direction shown by an arrow 54a. Each of the magnets 53 and 54 may be formed of stacked magnets. The magnetic-field generating part is not limited to a magnet, and the magnetic-field generating part may be an electromagnet formed by winding a coil around an iron material.

The first magnet 53 and the second magnet 54 are each connected to the yoke 55 at the opposite side from the piston rod 30 side. The yoke 55 is a ferrous member that forms a magnetic circuit between the first magnet 53 and the second magnet 54.

The hall element 56 is an element that outputs the intensity and the direction of the magnetic field by utilizing the Hall effect. The hall element 56 detects a component of the magnetic flux passing through the magnetic-flux detection surface 56a at right angle as shown by an arrow 56b in FIG. 2 and outputs voltage corresponding to an amount of the magnetic flux passed through (the magnetic flux density) and the direction of the magnetic flux passed through by taking the reference voltage (for example, 2.5V) as the center value. In other words, in a case in which the magnetic flux passes through in parallel with respect to the magnetic-flux detection surface 56a, because there is no magnetic flux passing through in the direction perpendicular to the magnetic-flux detection surface 56a, the hall element 56 outputs the reference voltage. In a case in which the magnetic flux flowing in the direction from the piston rod 30 towards the first magnetic detection unit 51 is detected, the output from the hall element 56 becomes greater than the reference voltage in accordance with the magnetic flux density passing through the magnetic-flux detection surface 56a. On the other hand, in a case in which the magnetic flux flowing in the direction from the first magnetic detection unit 51 towards the piston rod 30 is detected, the output from the hall element 56 becomes smaller than the reference voltage in accordance with the magnetic flux density passing through the magnetic-flux detection surface 56a. The output from the hall element 56 is amplified by an amplifier (not shown), is subjected to offset processing such that the reference voltage becomes zero, and is input to a stroke computing device (not shown) as the output value from the first magnetic detection unit 51. In other words, the output value from the first magnetic detection unit 51 is shifted from zero as the center to the positive side or the negative side in accordance with the direction of the magnetic flux passing through the magnetic-flux detection surface 56a. The hall element 56 may be set such that the value smaller than the reference voltage is output when the magnetic flux flowing in the direction from the piston rod 30 towards the first magnetic detection unit 51 is detected, and such that the value greater than the reference voltage is output when the magnetic flux flowing in the direction from the first magnetic detection unit 51 towards the piston rod 30 is detected.

The hall element 56 is received in the casing 58 together with the first magnet 53 and the second magnet 54 in a state in which the hall element 56 is attached to the positioning member 57. Here, the one end of the positioning member 57 is connected to the yoke 55 and the other end of the positioning member 57 is attached to the hall element 56. As shown in FIG. 2, the hall element 56 is arranged such that the magnetic-flux detection surface 56a is positioned on the same plane as one end surfaces of the first magnet 53 and the second magnet 54 in the axial direction. Therefore, it is possible to bring the hall element 56, the first magnet 53, and the second magnet 54 closer to the piston rod 30 as much as possible.

The positioning member 57 and the casing 58 are made of non-magnetic member such as aluminum alloy, etc. Therefore, a magnetic path is not formed in the positioning member 57 and the casing 58. The hall element 56 may be assembled to the casing 58 directly without using the positioning member 57. In this case, in order to prevent detachment of the hall element 56 from the casing 58, it is preferred to fill the interior of the casing 58 with a resin. In addition, the casing 58 may not be provided, and the hall element 56, the first magnet 53, and the second magnet 54 may be integrated by resin molding.

A surface of the casing 58 facing the piston rod 30 is formed to have a concaved curved shape so as to conform with the shape of the side surface 30c of the piston rod 30. Therefore, it is possible to bring the first magnetic detection unit 51 closer to the piston rod 30 having a curved surface as much as possible.

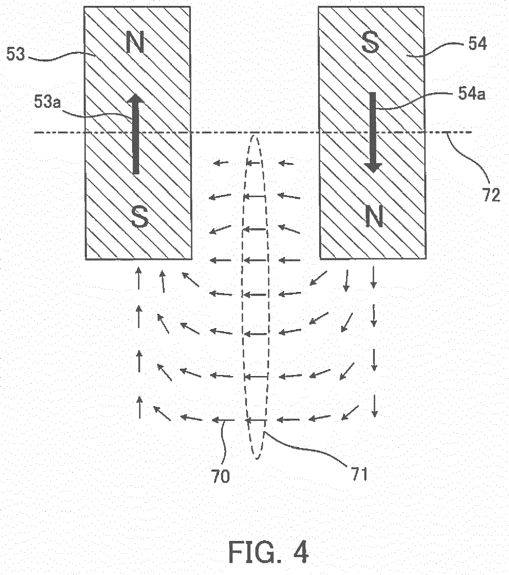

Next, a positional relationship of the first magnet 53 and the second magnet 54 with the hall element 56 will be described with reference to FIG. 4.

The first magnet 53 and the second magnet 54 are arranged such that the magnetized directions 53a and 54a become parallel to each other, and a synthetic magnetic field synthesized with the magnetic field of the first magnet 53 and the magnetic field of the second magnet 54 is formed between the first magnet 53 and the second magnet 54. In FIG. 4, the direction of the magnetic flux in the synthetic magnetic field when the intensities of the magnetic fields of the first magnet 53 and the second magnet 54 are the same is shown by arrows 70. In FIG. 4, for the sake of convenience of description, only the synthetic magnetic field between the south pole of the first magnet 53 and the north pole of the second magnet 54 where the hall element 56 is to be arranged is shown.

As shown in FIG. 4, although the direction of the magnetic flux in the synthetic magnetic field has substantially parabolic shape in the synthetic magnetic field, there is a parallel region 71 in which the direction of the magnetic flux flowing from the second magnet 54 towards the first magnet 53 is parallel to the direction in which the first magnet 53 and the second magnet 54 are arranged, in other words, there is a region in which the direction of the magnetic flux flowing from the second magnet 54 towards the first magnet 53 is perpendicular to the magnetized directions 53a and 54a of the first magnet 53 and the second magnet 54. If the magnetic force of the first magnet 53 and the magnetic force of the second magnet 54 are exactly the same, the parallel region 71 extends along the magnetized directions 53a and 54a at exactly the middle region between the first magnet 53 and the second magnet 54. The hall element 56 in this embodiment is arranged at a position where the magnetic-flux detection surface 56a becomes parallel to the direction of the magnetic flux in the synthetic magnetic field. In other words, the hall element 56 is arranged in the parallel region 71 between the first magnet 53 and the second magnet 54 such that the magnetic-flux detection surface 56a becomes parallel to the direction of the magnetic flux in the synthetic magnetic field.

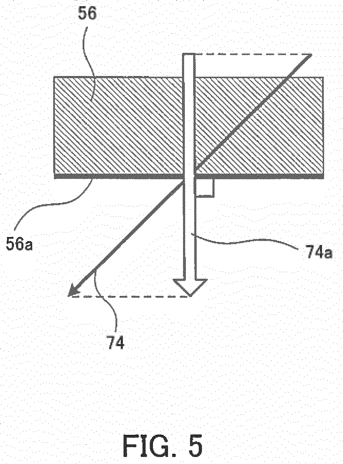

Here, when a magnetic body, etc. is brought closer to the first magnet 53 or the second magnet 54 and a disturbance is caused in the synthetic magnetic field to cause a change in the direction of the magnetic flux in the parallel region 71, the direction of the magnetic flux passing through the magnetic-flux detection surface 56a is no longer parallel to the magnetic-flux detection surface 56a. As described above, when the magnetic flux passes through in parallel with respect to the magnetic-flux detection surface 56a, the output from the hall element 56 becomes zero. However, for example, as shown in FIG. 5, when a magnetic flux 74 that is not parallel to the magnetic-flux detection surface 56a passes through, a magnetic-flux component 74a of this magnetic flux 74 that is perpendicular to the magnetic-flux detection surface 56a is detected by the hall element 56, and the hall element 56 outputs the voltage in accordance with the amount and the direction of the magnetic-flux component 74a passing through. As described above, in a state in which there is no disturbance in the synthetic magnetic field, by arranging the hall element 56 at the position where the magnetic-flux detection surface 56a becomes parallel to the direction of the magnetic flux, it is possible to reliably detect with the hall element 56 the change in the direction of the magnetic flux in the synthetic magnetic field, in other words, it is possible to reliably detect with the hall element 56 that the magnetic body, etc. has passed a close proximity to the first magnet 53 or the second magnet 54.

In addition, as described above, the hall element 56 is arranged such that the magnetic-flux detection surface 56a is positioned on the same plane as the one end surfaces of the first magnet 53 and the second magnet 54 in the axial direction. Only by arranging the hall element 56 in this manner, it is possible to bring the first magnet 53 and the second magnet 54 closer to a detection target such as the magnetic body, etc., as much as possible. The direction of the magnetic flux in the synthetic magnetic field changes greatly by following the detection target in a case in which the detection target is in the position close to the first magnet 53 and the second magnet 54, in other words, in the position where the magnetic field is strong than in a case in which the detection target is in the position away from the first magnet 53 and the second magnet 54, in other words, in the position where the magnetic field is weak. In addition, the hall element 56 is arranged in a region close to the magnetic poles of the first magnet 53 and the second magnet 54, in other words, in the region where the magnetic flux density is relatively high. Therefore, because the magnetic flux density passing through the hall element 56 is large, even when the change in the direction of the magnetic flux is small, it is possible to reliably detect with the hall element 56 the change in the direction of the magnetic flux in the synthetic magnetic field that is caused when the detection target passes through the close proximity to the first magnet 53 and the second magnet 54. As a result, the magnetic detection unit 51 can reliably detect a movement of the detection target passing through the close proximity to the magnetic detection unit 51. The magnetic-flux detection surface 56a may be positioned not on the surface of the hall element 56 on the piston rod 30 side, but on the surface of the hall element 56 on the opposite side of the piston rod 30 or on the center plane of the hall element 56. Even when the magnetic-flux detection surface 56a is positioned as described above with respect to the hall element 56, the hall element 56 is arranged in the magnetic detection unit 51 such that the magnetic-flux detection surface 56a is positioned on the same plane as one end surfaces of the first magnet 53 and the second magnet 54 in the axial direction.

In addition, in the vicinity of the middle position of the first magnet 53 and the second magnet 54 in the axial direction, which is shown by a two-dot chain line 72 in FIG. 4, the intensity of the magnetic field is very low, and the direction of the magnetic flux does not change substantially even when the magnetic body, etc. is brought closer to the first magnet 53 or the second magnet 54. Therefore, it is preferred that the hall element 56 be arranged in the parallel region 71 that is the region away from the middle position of the first magnet 53 and the second magnet 54 in the axial direction.

The scales 60 that are provided so as to oppose the first magnetic detection unit 51 and the second magnetic detection unit 52 are non-magnetic bodies that are formed to have a groove shape on the outer circumference of the piston rod 30, which is a magnetic body. The scales 60 are formed by melting the outer circumferential surface of the piston rod 30 with a laser beam radiated by a laser device as a local heating device and by austenitizing the outer circumferential surface by doping Ni or Mn thereto.

The piston rod 30 may be formed of a non-magnetic body, and in this case, the scales 60 are formed as magnetic bodies by melting the piston rod 30 by a laser device and by doping Sn etc. Means to perform local heating is not limited to the use of a laser beam, and any means capable of performing local heating, such as use of electron beam, high frequency induction heating, arc discharge, and so forth, may also be used.

As shown in FIG. 2 in an enlarged view, the scales 60 each have a predetermined width W1 in the advancing/retracting direction of the piston rod 30 and are provided along the advancing/retracting direction of the piston rod 30 with predetermined intervals P1. As shown in FIG. 2, with respect to the scales 60, the first magnetic detection unit 51 is arranged such that the direction in which the first magnet 53 and the second magnet 54 are aligned is parallel to the advancing/retracting direction of the piston rod 30. In other words, as the piston rod 30 is advancing/retracting, the scales 60 move across the first magnet 53 and the second magnet 54 one by one, not at the same time. In addition, the widths W1 of the scales 60 and the sizes of the intervals P1 for providing the scales 60 may the same or different.

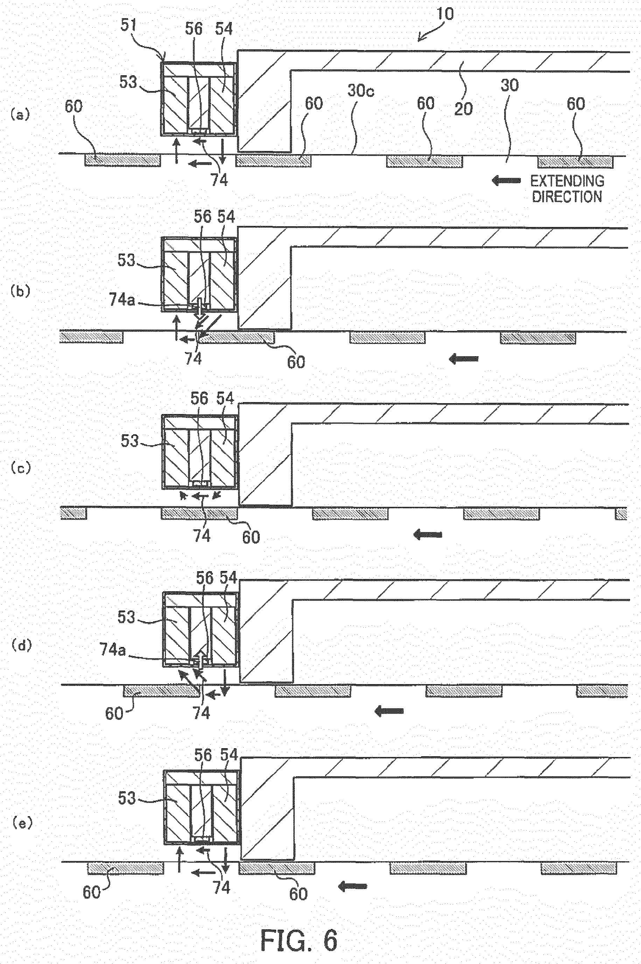

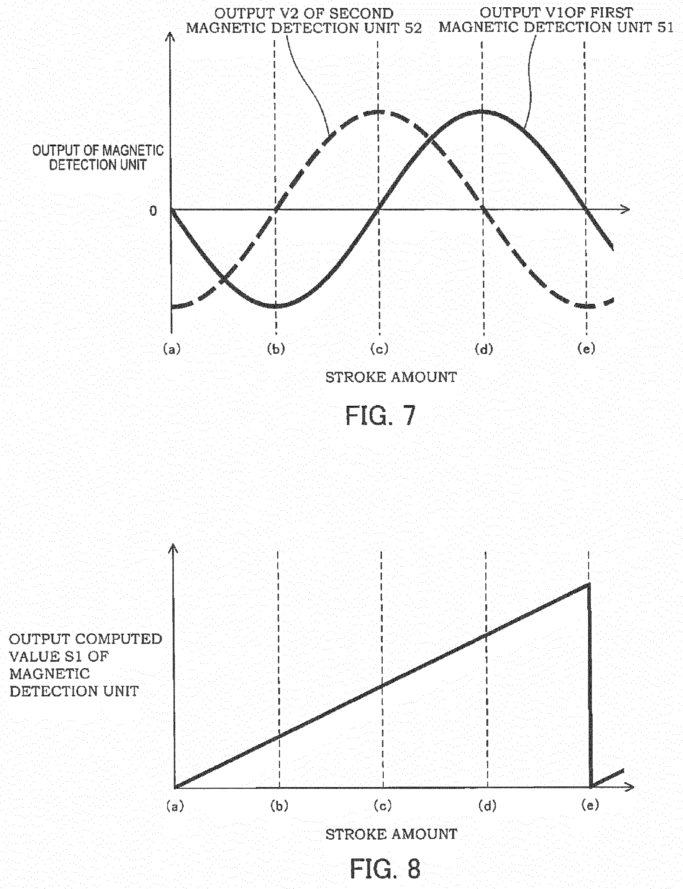

Next, detection steps of the stroke amount of the piston rod 30 by the stroke detector 100 will be described with reference to FIGs. 6 and 7. FIG. 6 is a diagram showing how the magnetic flux direction around the hall element 56 is changed as the positions of the scales 60 with respect to the first magnetic detection unit 51 are changed when the cylinder 10 is extended. FIG. 7 is a graph showing the change in the output from the first magnetic detection unit 51 and the second magnetic detection unit 52 when the piston rod 30 is advanced with respect to the cylinder 10 from (a) to (e) in FIG. 6.

In the state shown in (a) in FIG. 6, the first magnetic detection unit 51 is in a state in which the first magnet 53 and the second magnet 54 oppose the side surface 30c of the piston rod 30 where the scale 60 is not provided. Because the piston rod 30 is made of the magnetic body, the magnetic circuit is formed in the piston rod 30. The magnetic circuit formed at this time is formed to have a ring shape by passing through the first magnet 53, the yoke 55, the second magnet 54, and the piston rod 30. At this time, the magnetic flux 74 in the vicinity of the hall element 56 passes through in parallel with the magnetic-flux detection surface 56a. In other words, because there is no magnetic flux passing through in the perpendicular direction with respect to the magnetic-flux detection surface 56a, the output from the hall element 56 becomes the reference voltage. Therefore, as shown in FIG. 7, an output value V1 of the first magnetic detection unit 51 output via the amplifier becomes zero.

As the piston rod 30 is advanced slightly from the state shown in (a) in FIG. 6 and the state is shifted to the state shown in (b) in FIG. 6, a state in which the second magnet 54 opposes the scale 60 is achieved. In this state, the magnetic flux flowing from the second magnet 54 towards the piston rod 30 flows to a part of the piston rod 30 where the scale 60 opposing the first magnet 53 is not provided by avoiding the scale 60, which is the non-magnetic body. Because of this effect, the direction of the magnetic flux 74 in the vicinity of the hall element 56 is changed such that the state is shifted from the parallel state with respect to the magnetic-flux detection surface 56a to the inclined state towards the piston rod 30. Therefore, the hall element 56 detects the amount and the direction of the magnetic-flux component 74a passing through perpendicularly to the magnetic-flux detection surface 56a. Therefore, in the state shown in (b) in FIG. 6, the output from the hall element 56 is smaller than the reference voltage, and as shown in FIG. 7, the output value V1 from the first magnetic detection unit 51 is maximized towards the negative side.

While the state is shifted from the state shown in (a) in FIG. 6 to the state shown in (b), the direction of the magnetic flux flowing from the piston rod 30 towards the first magnet 53 does not change substantially, whereas the inclination of the magnetic flux flowing towards the piston rod 30 from the second magnet 54 by avoiding the scale 60 is gradually increased as the scale 60 opposes the second magnet 54. Together with this change in the inclination, the inclination of the magnetic flux passing through the hall element 56 is gradually increased from the parallel state with respect to the magnetic-flux detection surface 56a. Therefore, as shown by the solid line in FIG. 7, the output value V1 from the first magnetic detection unit 51 is gradually decreased while the state is shifted from the state shown in (a) to the state shown in (b).

When the piston rod 30 is slightly advanced further and the state is shifted to the state shown in (c) in FIG. 6, a state in which the first magnet 53 and the second magnet 54 oppose the scale 60 is achieved. When the first magnet 53 and the second magnet 54 oppose the scale 60, which is the non-magnetic body, as described above, the magnetic flux flows from the second magnet 54 towards the first magnet 53 through a gap between the piston rod 30 and the first magnetic detection unit 51. Therefore, the direction of the magnetic flux 74 in the vicinity of the hall element 56 becomes parallel to the magnetic-flux detection surface 56a. Therefore, as shown in FIG. 7, the output value V1 from the first magnetic detection unit 51 becomes zero again.

When the state is shifted to the state shown in (d) in FIG. 6, a state in which the first magnet 53 opposes the scale 60 is achieved. In this state, the magnetic flux flows from the second magnet 54 towards a part of the piston rod 30 where the scale 60 is not provided, while the magnetic flux flowing from the piston rod 30 towards the first magnet 53 flows towards the first magnet 53 from the part where the scale 60 opposing the second magnet 54 is not provided. Because of this effect, the direction of the magnetic flux 74 in the vicinity of the hall element 56 is changed such that the state is shifted from the parallel state with respect to the magnetic-flux detection surface 56a to the inclined state towards the first magnet 53 from the part where the scale 60 opposing the second magnet 54 is not provided. Therefore, the hall element 56 detects the amount and the direction of the magnetic-flux component 74a passing through perpendicularly to the magnetic-flux detection surface 56a. Therefore, in the state shown in (d) in FIG. 6, as shown in FIG. 7, the output from the hall element 56 becomes greater than the reference voltage, and the output value V1 from the first magnetic detection unit 51 is maximized towards the positive side.

The state shown in (e) in FIG. 6 is the same as the state shown in (a), and the output value V1 from the first magnetic detection unit 51 is zero. As shown by the solid line in FIG. 7, the output value V1 from the first magnetic detection unit 51 changes sinusoidally in accordance with the stroke amount of the piston rod 30.

The output from the second magnetic detection unit 52 changes similarly to that of the first magnetic detection unit 51, and the second magnetic detection unit 52 is attached to the cylinder head 20a such that an output value V2 therefrom is offset from the output value V1 from the first magnetic detection unit 51 by a quarter cycle. Therefore, as shown by the broken line in FIG. 7, the output value V2 from the second magnetic detection unit 52 changes cosinusoidally.

From the output value V1 from the first magnetic detection unit 51 and the output value V2 from the second magnetic detection unit 52 shown in FIG. 7, a computed value S1 proportional to the stroke amount is computed as shown in FIG. 8. The computed value S1 is obtained from the following equation (1).

$$S1 = \{atan2\ (V2,\ V1) + \pi\}/2\pi \quad (1)$$

Wherein:

atan2 (x, y) is a function (arc tangent function) for calculating an angle ($-\pi$ to $\pi$) between x axis and a vector starting at the origin and ending at a coordinate (x, y);
V1 is the output value from the first magnetic detection unit 51; and
V2 is the output value from the second magnetic detection unit 52.

The computed value S1 that is obtained from the above equation (1) is a value from 0 to 1, and shows the proportion relative to a stroke length taking (a) to (e) in FIG. 6 as one cycle, in other words, relative to the length obtained by adding the width W1 of the scales 60 and the interval P1 for providing the scales 60. Therefore, by multiplying the computed value S1 by the stroke length corresponding to the one cycle and by counting the number of times the computed value S1 has switched from one to zero, it is possible to compute an absolute stroke amount of the piston rod 30 with respect to the cylinder tube 20.

According to the above-mentioned embodiment, the advantages described below are afforded.

With the magnetic detection units 51 and 52, the hall element 56 is arranged at the position where the magnetic-flux detection surface 56a becomes parallel to the direction of the magnetic flux in the synthetic magnetic field generated by the first magnetic field of the first magnet 53 and the second magnetic field of the second magnet 54. When the hall element 56 is arranged as described above, because the magnetic flux in the synthetic magnetic field is not detected by the magnetic-flux detection surface 56a, the detected value by the hall element 56 becomes zero. In other words, because the setting of the maximum detection range of the hall element 56 is not affected by the intensity of the magnetic field of the first magnet 53 and the intensity of the magnetic field of the second magnet 54, it is possible to utilize the hall element 56 having a small detection range and a high resolution. As a result, it is possible to precisely detect the slight change in the direction of the magnetic flux that is caused as the detection target passes through the proximity to the magnetic detection units 51 and 52.

In addition, with the stroke detector 100 including the magnetic detection units 51 and 52, the hall element 56 can detect the slight change in the direction of the magnetic flux caused as the scales 60 provided in the piston rod 30 pass through the proximity to the magnetic detection units 51 and 52. As a result, it is possible to precisely detect the stroke amount of the piston rod 30 with respect to the cylinder tube 20.

Next, a modification of the magnetic detection units 51 and 52 according to the above-mentioned embodiment will be described.

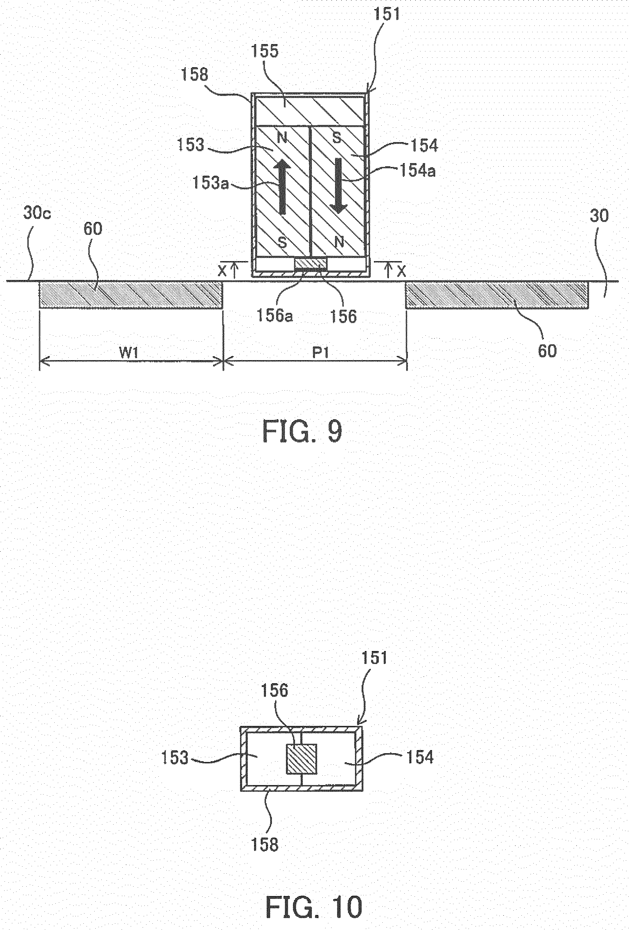

In the above-mentioned embodiment, the hall element 56 is arranged between the first magnet 53 and the second magnet 54. Instead of this configuration, as shown in FIGs. 9 and 10, a hall element 156 may be arranged on one end surfaces side of a first magnet 153 and a second magnet 154.

Even when the hall element 156 is arranged as described above, similarly to the above-mentioned embodiment, a magnetic-flux detection surface 156a becomes parallel to the direction of the magnetic flux in the synthetic magnetic field generated by the first magnet 153 and the second magnet 154.

Specifically, as shown in FIGs. 9 and 10, in a magnetic detection unit 151, the first magnet 153 and the second magnet 154 are arranged in a casing 158 so as to be contacted to each other. The hall element 156 is arranged not between the first magnet 153 and the second magnet 154, but on the end surfaces of the first magnet 153 and the second magnet 154 on the piston rod 30 side. In other words, the magnetic-flux detection surface 156a of the hall element 156 is positioned away from the one end surfaces of the first magnet 153 and the second magnet 154 in the axial direction towards the outside in the axial direction.

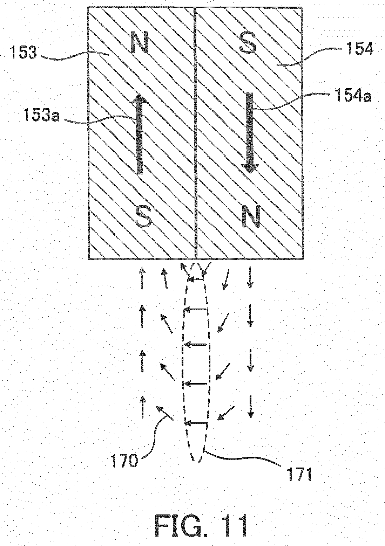

In this case, the direction of the magnetic flux in the synthetic magnetic field generated by the first magnet 153 and the second magnet 154 is in a state shown in FIG. 11. As described above, even with the synthetic magnetic field generated by the first magnet 153 and the second magnet 154 that are in the contacted state, similarly to the above-mentioned embodiment, like the magnetic flux in a parallel region 171, there is a region in which the direction of the magnetic flux flowing from the second magnet 154 towards the first magnet 153 is parallel to the direction in which the first magnet 153 and the second magnet 154 are arranged. In other words, by arranging the hall element 156 in the parallel region 171 shown in FIG. 11, the similar operational advantages as those of the above-mentioned embodiment are afforded.

Specifically, as shown in FIG. 9, the hall element 156 is arranged such that the magnetic-flux detection surface 156a is positioned away from the one end surfaces of the first magnet 153 and the second magnet 154 in the axial direction towards the outside in the axial direction. Therefore, the hall element 156 is positioned between the detection target and the first magnet 153 and the second magnet 154. Because the detection target is positioned so as to be away from the first magnet 153 and the second magnet 154, in the region between the detection target and the first magnet 153 and the second magnet 154, in other words, in the region in which the hall element 156 is provided, the direction of the magnetic flux is changed greatly as the detection target passes through the proximity to the first magnet 153 and the second magnet 154. Therefore, the hall element 156 arranged between the detection target and the first magnet 153 and the second magnet 154 can reliably detect the change in the direction of the magnetic flux in the synthetic magnetic field that is caused as the detection target passes through the proximity to the first magnet 153 and the second magnet 154. As a result, the magnetic detection unit 151 can reliably detect the movement of the detection target passing through the close proximity to the magnetic detection unit 151.

In addition, as shown in FIG. 10, because the length of the magnetic detection unit 151 in the advancing/retracting direction of the piston rod 30 is shorter than those of the magnetic detection units 51 and 52 of the above-mentioned embodiment, it is possible to easily achieve installation even when the installation space for the magnetic detection unit 151 is limited.

Next, an modification of the stroke detector 100 including the magnetic detection units 51 and 52 according to the above-mentioned embodiment will be described.

In the above-mentioned embodiment, a plurality of the scales 60 are formed along the advancing/retracting direction. Instead of this configuration, the helical scale 60 may be provided along the axial direction of the piston rod 30. In this case, each of the magnetic detection units 51 and 52 is arranged such that the direction in which the first magnet 53 and the second magnet 54 are arranged is perpendicular to the advancing/retracting direction of the piston rod 30, and each of the magnetic detection units 51 and 52 is arranged so as to oppose the scale 60 that is displaced in the circumferential direction in accordance with the stroke amount of the piston rod 30. Also in this case, similarly to the above-mentioned embodiment, it is possible to compute the absolute stroke amount of the piston rod 30 with respect to the cylinder tube 20 on the basis of the output values from the respective magnetic detection units 51 and 52.

Configurations, operations, and effects of the embodiments according to the present invention will be collectively described below.

The magnetic detection unit (51, 151) includes: the first magnet (53, 153) configured to generate the first magnetic field; the second magnet (54, 154) arranged in parallel with the first magnet (53, 153), the second magnet (54, 154) being configured to generate the second magnetic field in the direction opposite to the direction of the first magnetic field; and the hall element (56, 156) having the magnetic-flux detection surface (56a, 156a), the hall element (56, 156) being configured to output signals corresponding to the magnetic flux density passing through the magnetic-flux detection surface (56a, 156a). The hall element (56, 156) is arranged at the position where the direction of the magnetic flux in the synthetic magnetic field of the first magnetic field and the second magnetic field is parallel to the magnetic-flux detection surface (56a, 156a).

In this configuration, the hall element (56, 156) is arranged at the position where the direction of the magnetic flux in the synthetic magnetic field of the first magnetic field of the first magnet (53, 153) and the second magnetic field of the second magnet (54, 154) becomes parallel to the magnetic-flux detection surface (56a, 156a). When the hall element (56, 156) is arranged as described above, because the magnetic flux of the synthetic magnetic field is not detected by the magnetic-flux detection surface (56a, 156a), the detected value by the hall element (56, 156) becomes zero. In other words, because the setting of the maximum detection range of the hall element (56, 156) is not affected by the intensity of the magnetic field of the first magnet (53, 153) and the intensity of the magnetic field of the second magnet (54, 154), it is possible to utilize the hall element (56, 156) having a small detection range and a high resolution. As a result, it is possible to precisely detect the slight change in the direction of the magnetic flux that is caused as the detection target passes through the proximity to the magnetic detection unit (51, 52, 151), and at the same time, it is possible to improve the detection precision of the magnetic detection unit (51, 151).

In addition, the hall element 56 is arranged such that the magnetic-flux detection surface 56a is positioned on the same plane the one end surfaces of the first magnet and the second magnet in the axial direction.

In this configuration, the magnetic-flux detection surface 56a of the hall element 56 is positioned on the same plane as the one end surfaces of the first magnet 53 and the second magnet 54 in the axial direction. Therefore, it is possible to bring the hall element 56, the first magnet 53, and the second magnet 54 closer to the detection target as much as possible. The direction of the magnetic flux in the synthetic magnetic field changes greatly by following the detection target in a case in which the detection target is in the position close to the first magnet 53 and the second magnet 54, in other words, in the position where the magnetic field is strong than a case in which the detection target is in the position away from the first magnet 53 and the second magnet 54, in other words, in the position where the magnetic field is weak. In addition, the hall element 56 is arranged in a region close to the magnetic poles of the first magnet 53 and the second magnet 54, in other words, in the region where the magnetic flux density is very high. Therefore, because the magnetic flux density passing through the hall element 56 is large, even when the change in the direction of the magnetic flux is small, it is possible to reliably detect with the hall element 56 the change in the direction of the magnetic flux in the synthetic magnetic field that is caused when the detection target passes through the close proximity to the first magnet 53 and the second magnet 54. As a result, the magnetic detection units 51 and 52 can reliably detect the movement of the detection target passing through the close proximity to the magnetic detection units 51 and 52.

In addition, the hall element 156 is arranged such that the magnetic-flux detection surface 156a is positioned away from the one end surfaces of the first magnet 153 and the second magnet 154 in the axial direction towards the outside in the axial direction.

In this configuration, the magnetic-flux detection surface 156a of the hall element 156 is positioned away from the one end surfaces of the first magnet 153 and the second magnet 154 in the axial direction towards the outside in the axial direction. Therefore, the hall element 156 is positioned between the detection target and the first magnet 153 and the second magnet 154. As described above, because the detection target is positioned so as to be away from the first magnet 153 and the second magnet 154, in the region between the detection target and the first magnet 153 and the second magnet 154, in other words, in the region in which the hall element 156 is provided, the direction of the magnetic flux is changed greatly as the detection target passes through the proximity to the first magnet 153 and the second magnet 154. Therefore, the hall element 156 arranged between the detection target and the first magnet 153 and the second magnet 154 can reliably detect the change in the direction of the magnetic flux in the synthetic magnetic field that is caused as the detection target passes through the proximity to the first magnet 153 and the second magnet 154. As a result, the magnetic detection unit 151 can reliably detect the movement of the detection target passing through the close proximity to the magnetic detection unit 151.

In addition, the first magnet 153 and the second magnet 154 are arranged along the axial direction in a contacted state.

In this configuration, the first magnet 153 and the second magnet 154 are arranged along the axial direction in a contacted state. Therefore, when compared with the case in which the hall element 156 is arranged between the first magnet 153 and the second magnet 154, the size of the magnetic detection unit 151 is reduced. Therefore, it is possible to easily achieve installation even when the installation space for the magnetic detection unit 151 is limited.

In addition, the stroke detector 100 includes: the scales 60 provided on the surface of the piston rod 30, the piston rod 30 being provided so as to be capable of advancing/retracting with respect to the cylinder tube 20, the scales 60 being provided along the advancing/retracting direction of the piston rod 30; and the magnetic detection unit (51, 52, 151) provided on the cylinder tube 20 so as to oppose the scales 60, the magnetic detection unit (51, 52, 151) being configured to output the signals corresponding to the magnetic field, the magnetic field being configured to be changed by the scales 60.

In this configuration, the hall element (56, 156) can detect the slight change in the direction of the magnetic flux caused as the scales 60 provided in the piston rod 30 pass through the proximity to the magnetic detection unit (51, 52, 151). As a result, it is possible to precisely detect the stroke amount of the piston rod 30 with respect to the cylinder tube 20.

The embodiments of the present invention described above are merely illustration of some application examples of the present invention and not of the nature to limit the technical scope of the present invention to the specific constructions of the above embodiments.

For example, the magnetic detection unit (51, 52, 151) is not limited to that detects the stroke amount of the cylinder 10, and the magnetic detection unit (51, 52, 151) may also be used as a sensor for detecting an approach and approaching direction of the magnetic body that moves in the direction perpendicular to the detection direction of the hall element (56, 156) of the magnetic detection unit (51, 52, 151).

The present application claims a priority based on Japanese Patent Application No. 2016-68269 filed with the Japan Patent Office on March 30, 2016, all the contents of which are hereby incorporated by reference.

**Claims**

1. A magnetic detection unit comprising:

   a first magnetic-field generating part configured to generate a first magnetic field;
   a second magnetic-field generating part arranged in parallel with the first magnetic-field generating part, the second magnetic-field generating part being configured to generate a second magnetic field in a direction opposite to a direction of the first magnetic field; and
   a magnetic detection element having a magnetic-flux detection surface, the magnetic detection element being configured to output a signal corresponding to a magnetic flux density passing through the magnetic-flux detection surface, wherein
   the magnetic detection element is arranged at a position where a direction of a magnetic flux in a synthetic magnetic field of the first magnetic field and the second magnetic field is parallel to the magnetic-flux detection surface.

2. The magnetic detection unit according to claim 1, wherein
   the magnetic detection element is arranged such that the magnetic-flux detection surface is positioned on a same plane as one end surfaces of the first magnetic-field generating part and the second magnetic-field generating part in an axial direction.

3. The magnetic detection unit according to claim 1, wherein
   the magnetic detection element is arranged such that the magnetic-flux detection surface is positioned away from the one end surfaces of the first magnetic-field generating part and the second magnetic-field generating part in the axial direction towards outside in the axial direction.

4. The magnetic detection unit according to claim 3, wherein
   the first magnetic-field generating part and the second magnetic-field generating part are arranged along the axial direction in a contacted state.

5. A stroke detector having the magnetic detection unit according to claim 1, the stroke detector comprising:

   a scale provided on a surface of a second member, the second member being provided so as to be capable of advancing and retracting with respect to a first member, the scale being provided along an advancing and retracting direction of the second member; and
   the magnetic detection unit provided on the first member so as to oppose the scales, the magnetic detection unit being configured to output a signal corresponding to a magnetic field, the magnetic field being configured to be changed by the scales.

FIG. 1

FIG. 2

FIG. 3

FIG. 4

FIG. 5

FIG. 6

OUTPUT V2 OF SECOND
MAGNETIC DETECTION UNIT 52

OUTPUT V1OF FIRST
MAGNETIC DETECTION UNIT 51

OUTPUT OF MAGNETIC
DETECTION UNIT

0

(a)        (b)        (c)        (d)        (e)

STROKE AMOUNT

## FIG. 7

OUTPUT COMPUTED
VALUE S1 OF
MAGNETIC
DETECTION UNIT

(a)        (b)        (c)        (d)        (e)

STROKE AMOUNT

## FIG. 8

FIG. 9

FIG. 10

153

153a

154

154a

FIG. 11

170

171

## INTERNATIONAL SEARCH REPORT

| International application No. |
|---|
| PCT/JP2017/004929 |

| A. CLASSIFICATION OF SUBJECT MATTER |
|---|
| *G01R33/02*(2006.01)i, *G01R33/07*(2006.01)i, *G01B7/00*(2006.01)i, *G01D5/14* (2006.01)i |

According to International Patent Classification (IPC) or to both national classification and IPC

| B. FIELDS SEARCHED |
|---|
| Minimum documentation searched (classification system followed by classification symbols) G01R33/02, G01R33/07, G01B7/00, G01D5/14 |

Documentation searched other than minimum documentation to the extent that such documents are included in the fields searched

| Jitsuyo Shinan Koho | 1922-1996 | Jitsuyo Shinan Toroku Koho | 1996-2017 |
|---|---|---|---|
| Kokai Jitsuyo Shinan Koho | 1971-2017 | Toroku Jitsuyo Shinan Koho | 1994-2017 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X<br>Y | US 2015/0022197 A1 (ALLEGRO MICROSYSTEMS, LLC), 22 January 2015 (22.01.2015), paragraphs [0030] to [0034]; fig. 3 to 4D & WO 2015/009532 A1 | 1,3-4<br>2,5 |
| Y | CN 103927811 A (MULTIDIMENSION TECHNOLOGY CO., LTD.), 16 July 2014 (16.07.2014), paragraph [0052]; fig. 3 & EP 3125202 A1 paragraph [0030]; fig. 3 & WO 2015/144046 A1 | 2 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 April 2017 (20.04.17) | 09 May 2017 (09.05.17) |

| Name and mailing address of the ISA/ | Authorized officer |
|---|---|
| Japan Patent Office 3-4-3,Kasumigaseki,Chiyoda-ku, Tokyo 100-8915,Japan | |
| | Telephone No. |

Form PCT/ISA/210 (second sheet) (January 2015)

**INTERNATIONAL SEARCH REPORT**

| International application No. |
| --- |
| PCT/JP2017/004929 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | EP 2988279 A1  (WUXI LER TECHNOLOGY CO., LTD.), 24 February 2016 (24.02.2016), paragraph [0021]; fig. 2 & JP 2016-518599 A paragraph [0022]; fig. 2 & CN 103226865 A        & WO 2014/169698 A1 & KR 10-2015-0128943 A   & US 2016/0084923 A1 | 2 |
| Y | JP 4-136713 A  (Kayaba Industry Co., Ltd.), 11 May 1992 (11.05.1992), page 3, upper left column, line 19 to upper right column, line 14; fig. 2 & US 5299143 A column 3, lines 26 to 45; fig. 1 & EP 0478394 A1         & DE 69119526 T2 | 5 |
| A | JP 10-227807 A  (Toyota Motor Corp.), 25 August 1998 (25.08.1998), paragraphs [0014] to [0043]; fig. 1 to 11 (Family: none) | 1-5 |

Form PCT/ISA/210 (continuation of second sheet) (January 2015)

**EP 3 407 077 A1**

**REFERENCES CITED IN THE DESCRIPTION**

**Patent documents cited in the description**

- JP 2004286662 A

- JP 2016068269 A